(19) Europäisches Patentamt
European Patent Office
Office européen des brevets

(11) **EP 3 258 282 A1**

(12) # DEMANDE DE BREVET EUROPEEN

(43) Date de publication:
**20.12.2017 Bulletin 2017/51**

(51) Int Cl.:
***G01R 31/36*** (2006.01)   *H01M 10/48* (2006.01)

(21) Numéro de dépôt: **17172398.4**

(22) Date de dépôt: **23.05.2017**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**MA MD**

(30) Priorité: **27.05.2016 FR 1654817**

(71) Demandeur: **Commissariat à l'Energie Atomique
et aux Energies
Alternatives
75015 Paris (FR)**

(72) Inventeur: **EDDAHECH, Akram
73000 CHAMBERY (FR)**

(74) Mandataire: **Novaimo
ActiTech 8
60 avenue Marie Curie
Archamps Technopole
74166 Saint Julien-en-Genevois Cedex (FR)**

(54) **PROCÉDÉ ET DISPOSITIF D'ÉVALUATION D'UN INDICATEUR D'ÉTAT DE SANTÉ D'UNE CELLULE D'UNE BATTERIE LITHIUM**

(57) La batterie lithium est composée d'une ou plusieurs cellules reliées entre elles. Le procédé d'évaluation comprend les étapes suivantes :
• détection (E2, E3) d'une première tension prédéterminée U1 puis d'une deuxième tension prédéterminée U2, de la cellule, respectivement à un premier instant t1 et à un deuxième instant t2, durant une phase de décharge ou de charge de la batterie ;
• calcul (E4) d'une quantité de charge électrique réelle, déchargée ou chargée par la cellule entre les instants t1 et t2, par intégration dans le temps d'un courant électrique à travers la cellule ;
• détermination (E5) de l'indicateur d'état de santé de la cellule par calcul d'un rapport entre ladite quantité de charge électrique réelle calculée et une quantité de charge électrique de référence qui serait déchargée ou chargée par ladite cellule en début de vie lors d'une phase de décharge ou de charge la faisant passer de l'une à l'autre des première et deuxième tensions prédéterminées U1 et U2.

**Figure 1B**

## Description

### Domaine technique de l'invention

L'invention concerne un procédé d'évaluation d'un indicateur d'état de santé d'une cellule d'une batterie lithium et un dispositif associé.

### État de la technique

Les batteries lithium, notamment les batteries lithium-ion, lithium-ion-polymère ou lithium-métal-polymère, sont largement utilisées dans le domaine automobile pour l'alimentation des véhicules automobiles électriques ou hybrides ainsi que dans le domaine de l'électronique nomade. Elles intègrent une ou plusieurs cellules, ou accumulateurs, connectées entre elles en série et/ou en parallèle.

En vieillissant, les performances des batteries lithium se dégradent, ce qui se traduit par une baisse de leur capacité et par une augmentation de leur résistance. Il en résulte une perte d'autonomie de la batterie et une baisse de sa durée de vie. Le vieillissement se produit au cours du temps, même pendant les périodes de non-utilisation de la batterie (on parle dans ce cas de « vieillissement calendaire »).

Le fonctionnement d'une batterie lithium est contrôlé par un système BMS (de l'anglais « Battery Management System ») de contrôle de la batterie. Le BMS surveille l'état de différents éléments de la batterie, tels que la tension totale et celle de chacune des cellules individuelles, la température, l'état de charge ou « SOC » (de l'anglais « State Of Charge »), le courant de charge ou de décharge, la capacité de la batterie et/ou l'état de santé ou « SOH » (de l'anglais « State Of Health »).

La détermination de l'état de santé ou du « SOH » d'une batterie lithium constitue l'une des tâches les plus importantes du BMS. L'état de santé d'une batterie est généralement représenté par un indicateur exprimé en pourcentage, une batterie neuve ayant un SOH de 1%.

Le suivi du SOH d'une batterie au cours du temps permet d'optimiser l'utilisation de la batterie et de se prémunir d'éventuels dysfonctionnements. A partir d'une valeur critique de SOH prédéterminée, par exemple égale 80%, on peut décider de remplacer la batterie par une batterie neuve pour éviter tout dysfonctionnement et éventuellement changer la batterie partiellement usagée de cadre d'utilisation afin de l'utiliser dans une seconde application différente de sa première application. Par exemple, une batterie peut être utilisée, en première application, pour alimenter un véhicule électrique ou hybride puis être exploitée, en deuxième application, pour alimenter des auxiliaires de centrales électriques ou de stations ou sous-stations de réseaux électriques. D'autres exemples d'usages de seconde vie sont présentés dans le document « Etude de la seconde vie des batteries des véhicules électriques et hybrides rechargeables » rapport ADEME, 2011.

Lorsque la batterie lithium intègre plusieurs cellules, la détermination de son SOH n'est pas aisée. Il existe plusieurs techniques de détermination de l'état de santé d'une telle batterie.

Une première méthode est décrite dans les documents [1] A. Farmann, W. Waag, A. Marongiu and D. U. Sauer, "Critical review of on-board capacity estimation techniques for lithium-ion batteries in electric and hybrid electric vehicles", Journal of Power Sources, vol. 281, pp. 114-130, 2015, et [2] V. Pop, H.J. Bergveld, P.H.L. Notten, J.H.G. Op het Veld and P.P.L. Regtien, "Accuracy analysis of the State-of-Charge and remaining run-time determination for lithium-ion batteries", Measurement, vol. 42, no. 8, pp. 1131-1138, 2009. Cette méthode s'appuie sur des mesures de la tension à vide de la batterie au repos, après relaxation de celle-ci, et sur un cumul d'ampères entre deux états relaxés de la batterie. La fiabilité de la méthode repose sur la précision de données de cartographie relatives à l'évolution de la tension à vide de la batterie en fonction de son état de charge et de la mesure de la tension à vide, laquelle dépend elle-même de la maîtrise de la relaxation de la batterie. Une telle méthode de détermination du SOH manque en définitive de fiabilité et de précision et n'est donc pas satisfaisante.

D'autres techniques basées sur des algorithmes adaptatifs sont utilisées. Elles font appel à des algorithmes d'identification complexes, nécessitant un traitement numérique lourd. En outre, leur mise en oeuvre nécessite qu'un modèle fin et précis de la batterie soit disponible.

La présente invention vient améliorer la situation. Elle propose notamment de déterminer l'état de santé, ou de façon plus générale un indicateur de l'état de santé, d'une batterie lithium de façon simple, fiable, rapide et précise.

### Objet de l'invention

A cet effet, l'invention concerne un procédé d'évaluation d'un indicateur d'état de santé d'une cellule d'une batterie lithium composée d'une ou plusieurs cellules reliées entre elles, comprenant les étapes suivantes :

détection d'une première tension prédéterminée U1 puis d'une deuxième tension prédéterminée U2, de la cellule, respectivement à un premier instant t1 et à un deuxième instant t2, durant une phase de décharge ou de charge de la batterie ;

calcul d'une quantité de charge électrique réelle, déchargée ou chargée par la cellule entre les instants t1 et t2, par intégration dans le temps d'un courant électrique à travers la cellule ;

détermination de l'indicateur d'état de santé de la cellule par calcul d'un rapport entre ladite quantité de charge électrique réelle calculée et une quantité de charge électrique de référence qui serait déchargée ou chargée par ladite cellule en début de vie lors d'une phase de décharge ou de charge la faisant passer de l'une à l'autre des première et deuxième tensions prédéterminées U1 et U2.

L'invention permet d'évaluer de façon fiable, précise et rapide l'état de santé d'une cellule de la batterie, pendant une charge ou une décharge de la batterie, sans qu'il soit nécessaire de la faire relaxer pour prendre des mesures.

Selon une réalisation, le procédé comprend les étapes suivantes :

- Opération de calibration comprenant la détermination de deux valeurs de tension prédéterminées U1 et U2 ;
- Détection comprenant la détection de la première tension prédéterminée U1 durant une phase de charge ou de décharge, ce qui fournit les données de début de l'étape de calcul et;
- Détection comprenant la détection de la deuxième tension prédéterminée U2, ce qui fournit les données de fin de l'étape de calcul.

Avantageusement, ladite quantité de charge électrique de référence est la quantité de charge électrique qui serait chargée ou déchargée par la cellule à un régime de référence, notamment au régime 1C. Ladite quantité de charge électrique de référence peut être déterminée à partir de données préétablies d'évolution de la tension d'une cellule de batterie en début de vie en fonction d'une donnée représentative de la charge électrique de ladite cellule.

Dans un mode de réalisation particulier, le procédé comprend une opération de calibration d'au moins un couple de tensions à détecter, contenant une première tension U1 et une deuxième tension U2, mise en oeuvre à partir de données préétablies relatives à l'évolution de la tension d'une cellule de batterie en début de vie en fonction d'une donnée représentative de la charge électrique de ladite cellule, à différents régimes de ladite cellule comprenant au moins un régime de référence, notamment le régime 1C, et un autre régime *i*, comprenant les étapes suivantes :

a) prendre un couple de tensions à tester, contenant une première tension test $Ut1_p$ et une deuxième tension test Ut2q ;

b) calculer une première estimation de la capacité *Capa$_i$* de la cellule en début de vie, au régime *i,* par la relation

$$Capa_i = Capa_{ref} * \frac{dQ_i}{dQ_{ref}}, \text{ où}$$

- *Capa$_{ref}$* est la capacité de la cellule en début de vie au régime de référence ;
- *dQ$_{ref}$* est la quantité de charge électrique qui serait déchargée ou chargée par la cellule en début de vie, au régime de référence, pour passer de l'une à l'autre des deux tensions $Ut1_p$ et $Ut2_q$ ;
- *dQ$_i$* est la quantité de charge électrique qui serait déchargée ou chargée par la cellule en début de vie, au régime *i*, pour passer de l'une à l'autre des deux tensions test $Ut1_p$ et $Ut2_q$ ;

c) calculer une deuxième estimation de la capacité *Capa$_i$* de ladite cellule en déterminant la quantité totale de charge électrique qui serait déchargée ou chargée par la cellule en début de vie, au régime *i*, pour passer de l'une à l'autre des deux tensions, minimale et maximale, de la cellule;

d) calculer une erreur d'estimation ($\varepsilon_i$) entre la première et la deuxième estimation de la capacité *Capa$_i$* de la cellule ;

e) choisir les première et deuxième tensions test $Ut1_p$ et $Ut2_q$ comme première et deuxième tension prédéterminée à détecter U1, U2 si l'erreur d'estimation est inférieure ou égale à un seuil fixé, notamment un seuil de 5%, avantageusement de 4%, avantageusement encore de 3%.

La calibration permet de déterminer au moins un couple d'une première tension U1 et d'une deuxième tension U2 à détecter pour évaluer l'état de santé d'une cellule de batterie en cours de vie. Elle est réalisée en utilisant des données préétablies d'évolution de la tension d'une cellule de batterie en fonction de sa charge électrique (ou d'un paramètre représentatif de sa charge électrique). Ces données sont généralement fournies par le fabricant de cellule ou de batterie. La calibration ne nécessite aucune mesure. Elle ne nécessite que des ressources de calcul et ces données préétablies relatives aux cellules de la batterie.

Dans un mode de réalisation particulier, on répète les étapes de calibration a) à e) en fixant l'une des deux tensions test, $Ut1_p$ et Ut2q, et en faisant varier l'autre tension test. Avantageusement, on répète les étapes de calibration a) à e), d'une part, en fixant la tension à tester Ut1$_p$ et en faisant varier la tension Ut2q à tester et, d'autre part, en fixant la tension test Ut2q et en faisant varier la tension test Ut1$_p$.

Grâce à cela, on teste un ensemble de couples de tensions.

Dans une variante de réalisation, pour chaque couple de tensions test Ut1$_p$ et Ut2$_q$, les étapes de calibration a) à d) sont mises en oeuvre pour différents régimes $i$ de la cellule, et les tensions test Ut1$_p$ et Ut2$_q$ sont choisies comme première et deuxième tension prédéterminée à détecter U1, U2 si les différentes erreurs d'estimation déterminées pour les différents régimes $i$ sont inférieures ou égales au seuil fixé.

Avantageusement, on détermine l'état de santé $SOH$ de la cellule par la relation suivante :

$$SOH = 100 * \frac{dQ_i}{dQ_{ref}}$$ où $dQ_i$ est la quantité de charge électrique déchargée ou chargée par la cellule entre les instants t1 et t2, déterminée par intégration dans le temps du courant électrique à travers la cellule au régime $i$, et $dQ_{ref}$ est la quantité de charge électrique qui serait déchargée ou chargée par la cellule en début de vie au régime de référence, pour passer de l'une à l'autre des deux tensions à détecter U1 et U2.

En variante, on détermine la capacité de la cellule par la relation suivante : $Capa_i = Capa_{ref} * \frac{dQ_i}{dQ_{ref}}$ où $dQ_i$ est la quantité de charge électrique déchargée ou chargée par la cellule entre les instants t1 et t2, déterminée par intégration dans le temps du courant électrique à travers la cellule au régime $i$, $dQ_{ref}$ est la quantité de charge électrique qui serait déchargée ou chargée par la cellule en début de vie au régime de référence, pour passer de l'une à l'autre des deux tensions à détecter U1 et U2, et $capa_{ref}$ est la capacité de la cellule en début de vie au régime de référence.

Dans un première mode de réalisation, le procédé comprend une étape préalable de détection d'une phase de charge ou de décharge de la batterie à régime constant, les étapes de détection de la première tension U1 à détecter et de la deuxième tension U2 à détecter étant déclenchées en cas de détection positive.

Dans un deuxième mode de réalisation, le procédé comprend une étape préalable de détection d'une phase de charge ou de décharge de la batterie à régime moyen faible inférieur à C/5, les étapes de détection de la première tension U1 à détecter et de la deuxième tension U2 à détecter étant déclenchées en cas de détection positive.

L'invention concerne aussi un procédé d'évaluation de l'indicateur d'état de santé d'une batterie à partir des indicateurs d'état de santé respectifs des différentes cellules de ladite batterie, caractérisé en ce qu'on détermine les indicateurs d'état de santé respectifs de toutes les cellules de la batterie par la mise en oeuvre du procédé précédemment défini puis on détermine que l'indicateur d'état de santé de la batterie est égal à l'indicateur d'état de santé le plus faible de tous les indicateurs d'état de santé respectifs des cellules de la batterie.

L'invention concerne également un dispositif d'évaluation d'un indicateur d'état de santé d'une cellule d'une batterie lithium composée d'une ou plusieurs cellules reliées entre elles, comprenant :

- un module de détection d'une première tension prédéterminée U1 puis d'une deuxième tension prédéterminée U2, de la cellule, respectivement à un premier instant t1 et à un deuxième instant t2, durant une phase de décharge ou de charge de la batterie ;
- un module de calcul d'une quantité de charge électrique réelle, déchargée ou chargée par la cellule entre les instants t1 et t2, par intégration dans le temps d'un courant électrique à travers la cellule ;
- un module de détermination de l'indicateur d'état de santé de la cellule par calcul d'un rapport entre ladite quantité de charge électrique réelle calculée et une quantité de charge électrique de référence qui serait déchargée ou chargée par ladite cellule en début de vie lors d'une phase de charge ou de décharge la faisant passer de l'une à l'autre des première et deuxième tensions U1 et U2.

Avantageusement, le dispositif comprend un module de calibration d'au moins un couple de tensions à détecter, contenant une première tension U1 et une deuxième tension U2, et une mémoire de stockage de données préétablies relatives à l'évolution de la tension U$_{cell}$ d'une cellule de batterie en début de vie en fonction d'une donnée représentative de la charge électrique de ladite cellule, à différents régimes de ladite cellule comprenant au moins un régime de référence et un autre régime $i$, le module de calibration étant agencé pour effectuer la calibration sur la base desdites données préétablies et pour :

a) prendre un couple de tensions à tester, contenant une première tension test Ut1$_p$ et une deuxième tension test Ut2q ;

b) calculer une première estimation de la capacité $capa_i$ de la cellule en début de vie, au régime $i$, par la relation

$$Capa_i = Capa_{ref} * \frac{dQ_i}{dQ_{ref}}, \text{ où}$$

- $Capa_{ref}$ est la capacité de la cellule en début de vie au régime de référence ;
- $dQ_{ref}$ est la quantité de charge électrique qui serait déchargée ou chargée par la cellule en début de vie, au régime de référence, pour passer de l'une à l'autre des deux tensions $Ut1_p$ et $Ut2_q$ ;
- $dQ_i$ est la quantité de charge électrique qui serait déchargée ou chargée par la cellule en début de vie, au régime $i$, pour passer de l'une à l'autre des deux tensions test $Ut1_p$ et $Ut2_q$ ;

c) calculer une deuxième estimation de la capacité $Capa_i$ de ladite cellule en déterminant la quantité totale de charge électrique qui serait déchargée ou chargée par la cellule en début de vie, au régime $i$, pour passer de l'une à l'autre des deux tensions, minimale et maximale, de la cellule;

d) calculer une erreur d'estimation entre la première et la deuxième estimation de la capacité $Capa_i$ de la cellule ;

e) choisir les première et deuxième tensions test $Ut1_p$ et $Ut2_q$ comme première et deuxième tension prédéterminée à détecter U1, U2 si l'erreur d'estimation est inférieure ou égale à un seuil fixé, notamment un seuil de 5%, avantageusement de 4%, avantageusement encore de 3%.

Avantageusement encore, le dispositif comprend un module de détection d'une phase de charge ou de décharge de la batterie à régime constant ou à régime moyen faible inférieur à C/5, la détection de la première tension U1 à détecter et de la deuxième tension U2 à détecter étant déclenchée en cas de détection positive.

## Description sommaire des dessins

L'invention sera mieux comprise à l'aide de la description suivante d'un mode de réalisation particulier du procédé d'évaluation d'un indicateur d'état de santé d'une cellule d'une batterie lithium composée de plusieurs cellules connectées de l'invention et d'un dispositif d'évaluation correspondant, en référence aux dessins annexés sur lesquels :

- La figure 1A représente un organigramme des étapes d'une opération de calibration du procédé d'évaluation selon un mode de réalisation particulier de l'invention ;
- La figure 1B représente un organigramme des étapes du procédé d'évaluation de l'état de santé des cellules d'une batterie, selon un mode de réalisation particulier de l'invention ;
- La figure 2 représente différentes courbes de charge et/ou de décharge d'une cellule à différents régimes ;
- La figure 3 représente un schéma bloc fonctionnel du dispositif d'évaluation selon une forme de réalisation particulière de l'invention.

## Description détaillée de modes de réalisation particuliers de l'invention

L'invention permet d'évaluer un indicateur ou paramètre d'état de santé d'une cellule d'une batterie lithium, par exemple une batterie lithium-ion, lithium-ion-polymère ou lithium-métal-polymère.

La batterie 1 est composée d'une ou plusieurs cellules $C_n$, ou accumulateurs électriques, identiques (avec $1 \leq n \leq N$ où N est le nombre de cellules de la batterie 1) et reliées entre elles en série et/ou en parallèle. Dans l'exemple de réalisation décrit ici, la batterie 1 comprend N cellules $C_n$ connectées en série. Ainsi, le courant électrique traversant chaque cellule $C_n$ est égal au courant (courant de charge, courant de décharge ou courant nul) de la batterie 1.

L'indicateur d'état de santé d'une cellule $C_n$ (ou de la batterie 1) est un paramètre (ou une grandeur) représentatif de l'état de santé de la cellule $C_n$ (ou de la batterie). Cet indicateur peut par exemple être le SOH (de l'anglais « State Of Health ») ou la capacité de la cellule $C_n$ (ou de la batterie 1). Le SOH est exprimé en pourcentage. Il vaut 1% lorsque la cellule (ou la batterie) est neuve et décroît au fur et à mesure du vieillissement de la cellule (ou de la batterie). La capacité est exprimée en ampère-heure. Elle représente la quantité de charge électrique que la cellule (ou la batterie) est capable de restituer après une charge complète. Dans l'exemple décrit ici, l'indicateur d'état de santé est le SOH.

Le procédé est mis en oeuvre par un système 2 de contrôle de la batterie 1, ou BMS (de l'anglais « Battery Management System »). Selon l'invention, le BMS 2 intègre un dispositif 3 d'évaluation de l'indicateur d'état de santé de la batterie, ici le SOH.

Le principe de l'évaluation de l'indicateur d'état de santé, par exemple le SOH, d'une cellule de la batterie selon l'invention est le suivant :

Lorsque, lors d'une charge ou d'une décharge de la batterie à régime constant (ou à régime faible, typiquement < $C/5$), la tension de la cellule passe d'une première tension U1 à une deuxième tension U2, prédéterminées, on calcule la quantité de charge électrique réelle déchargée ou chargée par la cellule par intégration du courant électrique à travers la cellule. Un indicateur d'état de santé de la cellule est ensuite évalué par un calcul du rapport entre cette quantité de charge électrique réelle calculée pour passer de U1 à U2 et une quantité de charge électrique de référence, ou théorique, pour passer de U1 à U2 en début de vie de la cellule.

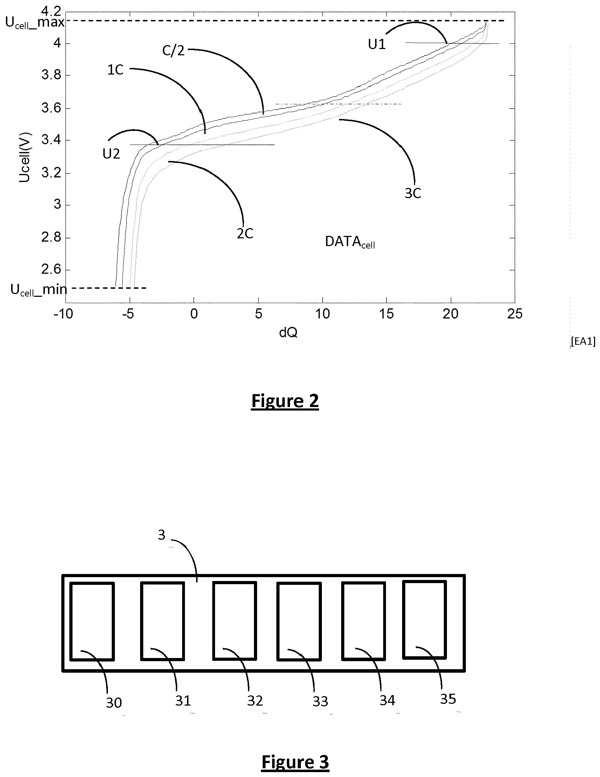

Le procédé comprend une opération de calibration E0 qui vise à déterminer, préalablement à l'évaluation de l'état de santé des cellules, une première tension U1 à détecter, ou une plage de premières tensions U1 à détecter, et une deuxième tension U2 à détecter, ou une plage de deuxièmes tensions U2 à détecter. Cette opération de calibration est réalisée sur la base de données préétablies DATA$_{cell}$ relatives à l'évolution de la tension U$_{cell}$ d'une cellule C$_n$ de la batterie 1 en fonction de sa charge électrique, ou en fonction d'une donnée représentative de sa charge électrique en début de vie de la cellule C$_n$, à différents régimes « i » (autrement dit pour différents courants électriques traversant la cellule). Ces données DATA$_{cell}$ peuvent être fournies par le fabricant de la batterie. Sur la figure 2, elles sont représentées par des courbes de charge ou de décharge d'une cellule C$_n$ de la batterie 1, en début de vie, à différents régimes i, i valant ici C/2, 1C, 2C et 3C, représentant les données DATA$_{cell}$. Ces courbes de charges ou de décharge représentent l'évolution de la tension U$_{cell}$ d'une cellule C$_n$ de la batterie 1 en fonction d'une donnée dQ représentant le cumul instantané de charge (c'est-à-dire la quantité de charge cumulée dans la batterie). La valeur « 0 » de dQ correspond à un RESET (ou une remise à zéro) du comptage des ampères-heures.

Par définition, on appelle :

- «régime 1C » le courant électrique permettant de décharger la capacité nominale Q de la cellule C$_n$ (ou la batterie) en 1 heure,
- « régime xC » le courant que fournirait la cellule C$_n$ (ou la batterie) en un nombre 1/x d'heure(s), qui est égal au produit de x et de Q, soit x.Q et est exprimé en A (ampères).

Prenons l'exemple d'une batterie ayant une capacité Q de 2Ah. Le régime 1C de cette cellule est égal à $\frac{Q(Ah)}{1(h)} = \frac{2Ah}{1h} = 2A$, soit un courant de 2A. Le régime 0,5C de cette même cellule est égal à $\frac{0,5 \times Q(Ah)}{1(h)} = \frac{0,5 \times 2Ah}{1h} = 1A$, soit un courant de 1 A. Le régime 2C de cette même cellule est égal à $\frac{2 \times Q(Ah)}{1(h)} = \frac{2 \times 2Ah}{1h} = 4A$, soit un courant de 4A.

Chaque courbe de la figure 2 représente l'évolution de la tension électrique U$_{cell}$ de la cellule Cn$_i$, exprimée en volts, en fonction de la donnée de charge électrique *dQ* exprimée en ampère-heure, de la cellule C$_n$. Lors d'une charge ou d'une décharge complète, la tension de la cellule, U$_{cell}$, varie entre une tension minimale U$_{cell\_}$min (ici égale à environ 2,5 V), lorsque la cellule C$_n$ est déchargée, et une tension maximale U$_{cell\_}$max (ici égale à environ 4,1 V), lorsque la cellule C$_n$ est complètement chargée.

Dans le mode de réalisation décrit ici, le régime 1C est un régime de référence.

L'opération de calibration est mise en oeuvre par un module de calibration 4 ici intégré au dispositif d'évaluation 3. Elle utilise uniquement les données DATA$_{cell}$.

Elle comprend une première étape E01, lors de laquelle le module de calibration 4 prend un couple de tensions à tester contenant une première tension test Ut1$_p$ et une deuxième tension test Ut2$_q$. La première tension test Ut1$_p$ et ici strictement supérieure à la deuxième tension test Ut2$_q$. En référence à la figure 2, le profil de charge de la cellule C$_n$ en début de vie peut être décomposé en trois phases de charge successives : une première phase de charge d'augmentation très rapide de la tension (ici entre 2,5V et 3,3V), une deuxième phase de charge d'augmentation lente de la tension (ici entre 3,3V et 3,65V) et une troisième phase de charge d'augmentation modérée à rapide de la tension (ici entre 3,65V et 4,1 V). Avantageusement, la tension test Ut1$_p$ et dans la troisième phase, par exemple en fin de troisième phase, et la tension test Ut2$_q$ est dans la deuxième phase, par exemple en début de deuxième phase.

Lors d'une étape suivante E02, le module de calibration 4 détermine une première estimation de la capacité *capa$_i$* d'une cellule C$_n$ de la batterie 1 en début de vie, ou à « BOL » (de l'anglais « Beginning Of Life »), au régime *i* (autrement dit traversée par le courant I$_i$), par la relation suivante :

$$Capa_i = Capa_{ref} * \frac{dQ_i}{dQ_{ref}} \qquad\qquad (1)$$

, où

- $Capa_{ref}$ représente la capacité de la cellule $C_n$ en début de vie au régime de référence ici 1C (traversée par un courant électrique de référence $I_{ref}$),
- $dQ_{ref}$ représente la quantité de charge électrique qui serait déchargée ou chargée par la cellule à BOL, ou en début de vie, au régime de référence ici 1C, pour passer de l'une à l'autre des deux tensions test $Ut1_p$ et $Ut2_q$,
- $dQ_i$ représente la quantité de charge électrique qui serait déchargée ou chargée par la cellule $C_n$ à BOL, ou en début de vie, au régime $i$, pour passer de l'une à l'autre des deux tensions test $Ut1_p$ et $Ut2_q$.

Les valeurs ci-dessus des paramètres $capa_{ref}$, $dQ_{ref}$ et $dQ_i$ sont déterminées à partir des données fabricant (ou « théoriques ») $DATA_{cell}$ d'évolution de la tension $U_{cell}$ d'une cellule $C_n$ à BOL de la batterie 1 en fonction de sa charge électrique, à différents régimes, telles que représentées sur la figure 2. La valeur de $Capa_{ref}$ correspond à la quantité totale de charge électrique que la cellule $C_n$ en début de vie, fonctionnant à régime de référence, ici 1C, permettant de faire passer la cellule de l'une à l'autre des deux tensions, minimale $U_{cell}$_min et maximale $U_{cell}$_max. Aucune mesure n'est donc nécessaire pour la mise en oeuvre de cette étape E02.

L'étape E02 est exécutée pour différents régimes $i$ de la cellule $C_n$ en début de vie, par exemple pour les régimes 0.5C, 2C et 3C. Ainsi, l'étape E02 comprend plusieurs sous-étapes, notées E02_i (en l'espèce E02_0.5C, E02_2C et E02_3C), de détermination d'une première estimation de la capacité $capa_i$, respectivement exécutées pour les trois régimes 0.5C, 2C et 3C. Ces premières estimations de la capacité $Capa_i$ aux régimes 0.5C, 2C et 3C sont notées $EST1\_Capa_{0.5C}$, $EST1\_Capa_{2C}$, $EST1\_Capa_{3C}$.

L'opération de calibration comprend une étape E03 de détermination d'une deuxième estimation de la capacité $capa_i$ de la cellule $C_n$ en début de vie, au régime $i$ (autrement dit traversée par le courant $I_i$), notée $EST2\_Capa_i$ avec i valant 0.5C, 2C ou 3C. Pour cette deuxième estimation, le module de calibration détermine la quantité totale de charge électrique $Qtot_i$ que la cellule $C_n$ en début de vie, fonctionnant à régime $i$ (autrement dit traversée par le courant $I_i$), doit décharger ou charger pour passer de l'une à l'autre des deux tensions, minimale $U_{cell}$_min et maximale $U_{cell}$_max. Pour déterminer $Qtot_i$, le module de calibration utilise les données fabricant $DATA_{cell}$ d'évolution de la tension $U_{cell}$ de la cellule $C_n$ en début de vie en fonction de sa charge électrique, à différents régimes, telles que représentées sur la figure 2. Aucune mesure n'est donc nécessaire. L'étape E03 est exécutée pour différents régimes $i$ de la cellule $C_n$ en début de vie, ici pour les régimes 0.5C, 2C et 3C. L'étape E03 comprend donc plusieurs sous-étapes E03_i, en l'espèce E03_0.5C, E03_2C et E03_3C, pour les trois régimes 1C, 2C et 3C respectivement. En variante, la valeur de la capacité $Capa_i$ d'une cellule $C_n$ au régime $i$ (ici 0.5C, 2C et 3C) en début de vie (c'est-à-dire à BOL) est une donnée fournie par le fabricant. Dans ce cas, l'étape E03 consiste simplement à obtenir cette donnée stockée en mémoire par exemple. Selon une autre variante, la quantité totale de charge électrique $Qtot_i$ est calculée par la mesure réelle de cette charge électrique lors d'une phase à régime i de la cellule $C_n$ en début de vie.

Puis, lors d'une étape de calcul E04, pour chaque régime $i$ considéré à l'exception du régime de référence 1C (ici 0.5C, 2C et 3C), on détermine l'erreur d'estimation $\varepsilon_i$ entre la première estimation et la deuxième estimation de la capacité $Capa_i$ de la cellule $C_n$ en début de vie ici par la relation suivante :

$$\varepsilon_i = 100 . \frac{\left| EST1_{Capa_i} - EST2_{Capa_i} \right|}{EST2_{Capa_i}}$$

Puis, lors d'une étape de test E05, on compare chaque erreur d'estimation $\varepsilon_i$ à un seuil S. L'erreur $\varepsilon_i$ étant exprimée en pourcentage, ce seuil S peut être fixé à 5% ou être inférieur à 5%, par exemple égal à 4%, ou encore à 3%. Lors d'une étape E06, le module de calibration choisit le couple de tensions testées $Ut1_p$ et $Ut2_q$, comme première et deuxième tension U1 et U2 à détecter, si les différents erreurs d'estimation $\varepsilon_i$ calculées pour les différents régimes considérés (ici 0.5C, 2C et 3C) sont inférieures ou égales au seuil fixé S. Sinon, le couple de tensions testées $Ut1_p$ et $Ut2_q$ n'est pas retenu pour jouer le rôle de couple de tensions à détecter U1, U2, autrement dit pour la calibration de U1 et U2 (étape E07).

La calibration vise à déterminer au moins un couple de tensions à détecter contenant une première tension U1 et une deuxième tension U2, strictement inférieure à U1. Plusieurs couples de tensions U1 et U2 peuvent être déterminées par calibration. Dans un mode de réalisation particulier, la calibration permet de déterminer une plage de premières tensions U1 à détecter et une plage de deuxièmes tensions U2 à détecter. Afin d'obtenir ces deux plages de tension, les étapes de calibration E01 à E06 ou E07 sont répétées de la façon suivante :

- d'une part, le module de calibration fixe la première tension test $Ut1_o$ et fait varier la deuxième tension test dans une plage délimitée par une borne inférieure et une borne supérieure en lui attribuant plusieurs valeurs successives notées $Ut2_q$ avec $0 \le q \le X$ ;
- d'autre part, le module de calibration fixe la deuxième tension test $Ut2_o$ et fait varier la première tension test dans une plage délimitée par une borne inférieure et une borne supérieure en lui attribuant plusieurs valeurs successives notées Ut1$_p$ avec $0 \leq p \leq X$.

Les deux plages de tensions testées respectivement pour la première tension test Ut1 et pour la deuxième tension test Ut2 ne se chevauchent pas. La borne inférieure de la première tension à tester Ut1 est égale ou supérieure à la borne supérieure de la deuxième tension à tester. Avantageusement, elles sont séparées par un gap de tension d'au moins 200mV. Par exemple, on fait varier la première tension à tester Ut1 entre 3,7V et 4,1V et on fait varier la deuxième tension à tester Ut2 entre 3,2V et 3,5V.

En variante, on pourrait aussi choisir le couple de tensions U1 et U2 pour lequel l'erreur d'estimation est la plus faible.

L'opération de calibration permet ainsi de prédéterminer une plage de valeurs pour la première tension U1 à détecter et une plage de valeurs pour la deuxième tension U2 à détecter, préalablement à la détermination de l'état de santé des cellules de la batterie 1 en cours de vie. Si on a le choix, on fixe la différence entre les deux tensions U1 et U2 au maximum.

On soulignera que la calibration ne nécessite aucune mesure, dans la mesure où des données fabricant DATA$_{cell}$ relatives à l'évolution de la tension d'une cellule de la batterie en fonction de sa charge électrique sont disponibles.

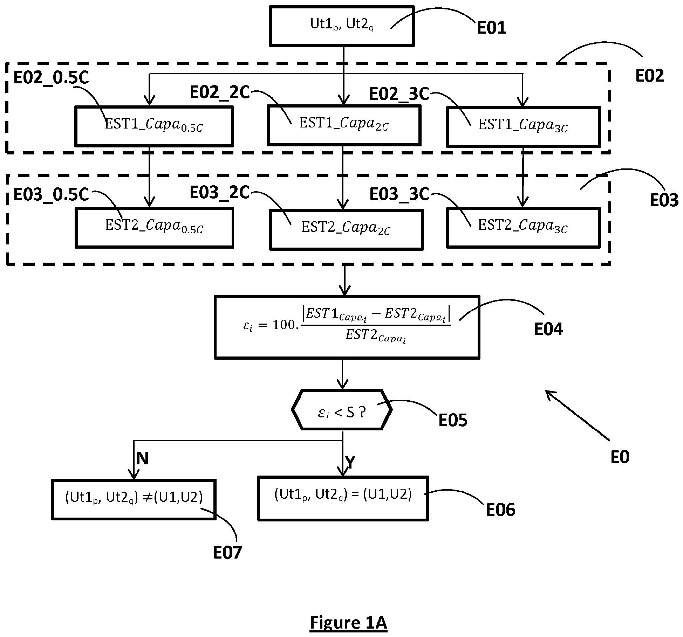

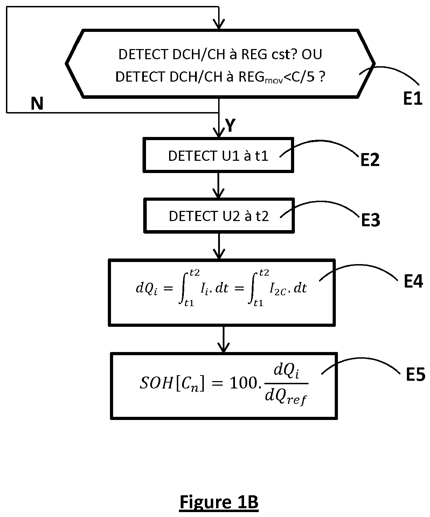

On va maintenant décrire en référence à la figure 1B, les étapes permettant d'évaluer l'état de santé SOH de chacune des cellules C$_n$ de la batterie 1, au cours de la vie de celle-ci. Ces étapes d'évaluation du SOH sont mises en oeuvre après la calibration d'au moins une tension U1 à détecter et une tension U2 à détecter, par le dispositif d'évaluation 3 du BMS 2 de la batterie 1. Il résulte donc de l'opération de calibration E0 la prédétermination de deux valeurs de tensions U1 et U2. Ces deux valeurs de tension prédéterminées U1 et U2 sont avantageusement stockées dans une mémoire de stockage des données. Dans l'exemple de réalisation décrit ici, en référence à la figure 2, à titre purement illustratif, la tension U1 vaut 4V et la tension U2 vaut 3,4V.

Le procédé comprend ici une étape E1 de détection d'une phase de décharge, ou de charge, de la batterie 1 à régime constant, un courant électrique constant traversant la batterie. Cette détection E1 est réalisée pendant un fonctionnement normal de la batterie 1, par exemple lorsque la batterie 1 alimente une charge ou est en train d'être rechargée. Cette E1 étape est mise en oeuvre par le dispositif d'évaluation du SOH.

Supposons ici, à titre d'exemple purement illustratif, que le dispositif d'évaluation du SOH 3 détecte une phase de décharge à régime constant 2C.

Sur détection E1 de la phase de décharge à régime constant 2C, le dispositif d'évaluation 3 cherche ensuite à détecter :

- la première tension U1 prédéterminée durant la calibration, lors d'une étape de détection E2 ;
- la deuxième tension U2 prédéterminée durant la calibration, lors d'une étape de détection E3.

Ainsi, l'étape de détection E2 comprend la comparaison de la tension mesurée (voire estimée) d'au moins une cellule Cn durant une phase de charge ou de décharge avec la première tension prédéterminée U1. Le procédé débute l'étape de calcul E4 dès que la tension mesurée est sensiblement égale à cette première tension prédéterminée U1. De plus, l'étape de détection E3 comprend la comparaison de la tension mesurée (voire estimée) durant une phase de charge ou de décharge avec la deuxième tension prédéterminée U2. Le procédé stoppe l'étape de calcul E4 dès que la tension mesurée est sensiblement égale à cette deuxième tension prédéterminée U2.

La première tension U1 est détectée à un instant t1, alors que la deuxième tension U2 est détectée à un instant ultérieur t2.

Notons que dans le cas où, lors de l'étape E1, on détecte une phase de charge à régime constant, on détecte évidemment d'abord la tension U2 puis la tension U1.

Le procédé comprend une étape de calcul E4, lors de laquelle le dispositif d'évaluation 3 calcule une quantité de charge électrique réelle $dQ_i$ (l'indice $i$ représentant le régime de la batterie, ici égal à 2C) déchargée par la cellule C$_n$ entre les instants t1 et t2, par intégration dans le temps du courant électrique à travers la cellule C$_n$. La batterie 1 étant ici composée de N cellules C$_n$ (avec n variant de 1 à N) reliées en série, le courant électrique à travers chaque cellule C$_n$ est le régime $i$, ici 2C (noté aussi courant I$_i$, ici I$_{2C}$), de la batterie 1. Ainsi, lors de l'étape E4, le dispositif d'évaluation 3 calcule la charge électrique $dQ_i$ par la relation suivante :

$$dQ_i = \int_{t1}^{t2} I_i . dt = \int_{t1}^{t2} I_{2C} . dt$$

Dans le cas où les étapes de détection E2 et E3 sont réalisées pendant une phase de charge, la quantité de charge électrique calculée lors de l'étape E4 correspond à la charge stockée ou chargée par la cellule $C_n$ entre les instants t1 et t2 pour passer de la tension U2 à la tension U1.

Ainsi, l'étape E4 débute, au moins partiellement, dès que la première tension prédéterminée est détectée et stoppe, au moins partiellement, lorsque la deuxième tension prédéterminée est détectée. Avantageusement, les valeurs des instants t1 et t2 sont mémorisés dans une mémoire de stockage. De plus, la quantité de charge et/ou le courant électrique peut être mesuré à chaque instant (selon une période choisie) entre les instants t1 et t2, et stocké dans une mémoire de stockage. En variante, la quantité de charge réelle est calculée en temps réel entre les instants t1 et t2. Ainsi, l'étape E4 peut être partiellement réalisée dès la première détection E2, et finalisée après la deuxième détection E3, et/ou totalement réalisée entre les deux instants t1 et t2. Autrement dit, la première détection E2 détermine la ou les données initiales pour l'étape de calcul E4 et la deuxième détection E3 détermine la ou les données finales pour l'étape de calcul E4. En effet, l'étape de calcul E4 repose sur le calcul d'une charge électrique entre les deux instants t1 et t2 déterminés par respectivement les deux étapes de détection E2, E3.

Le procédé comprend ensuite une étape E5 de détermination de l'état de santé SOH de la cellule $C_n$. Cette étape E5 comprend :

- une sous-étape de calcul d'un rapport entre la quantité de charge électrique réelle calculée $dQ_i$ et la quantité de charge électrique de référence correspondante $dQ_{ref}$, noté $\dfrac{dQ_i}{dQ_{ref}}$ ;

- une sous-étape de multiplication du rapport $\dfrac{dQ_i}{dQ_{ref}}$ par 100, afin d'obtenir le SOH exprimé en pourcentage.

La quantité de charge électrique de référence $dQ_{ref}$ correspondante est ici la quantité de charge électrique qui serait déchargée par la cellule $C_n$ en début de vie, lors d'une phase de décharge au régime de référence (ici le régime 1 C) la cellule étant traversée par le courant de référence $I_{ref}$ (ici égal à $I_{1C}$), faisant passer la tension aux bornes de la cellule $C_n$ de la tension U1 à la tension U2. La valeur de $dQ_{ref}$ est déterminée par simple calcul à partir des données fabricant $DATA_{cell}$, sans mesure.

La quantité de charge électrique qui serait chargée ou déchargée par la cellule en début de vie lors d'une phase de charge ou de décharge de la batterie à un régime de référence, notamment au régime 1C, faisant passer la cellule de l'une à l'autre des première et deuxième tensions U1 et U2.

Ainsi, le dispositif d'évaluation détermine l'état de santé SOH (en %) de la cellule $C_n$ par la relation suivante :

$$SOH[C_n] = 100.\frac{dQ_i}{dQ_{ref}}$$

Au lieu d'être réalisée pendant une phase de charge ou de décharge à régime constant, l'évaluation de l'état de santé d'une cellule de la batterie 1 est réalisée pendant une phase de charge ou de décharge de la batterie à régime moyen faible, c'est-à-dire inférieur à C/5. L'étape de détection E1 vise dans ce cas à détecter un régime moyen inférieur à C/5.

Dans le cas où on a calibré une première plage de premières tensions U1 et une deuxième plage de deuxièmes tensions U2, lors d'une phase de charge ou de décharge de la batterie, on détecte une première tension U1 appartenant à la première plage et une deuxième tension U2 appartenant à la deuxième plage.

Le procédé qui vient d'être décrit permet d'évaluer l'état de santé ou SOH de chaque cellule de la batterie 1. La connaissance des SOH de toutes les cellules de la batterie 1 permet au BMS de calculer d'autres grandeurs comme le SOC (de l'anglais « State of Charge ») ou état de charge de la batterie 1 et les puissances max. En outre, après avoir déterminé les indicateurs d'état de santé de toutes les cellules de la batterie 1, le BMS peut déterminer l'indicateur d'état de santé de la batterie 1 qui est égal à l'indicateur d'état de santé le plus faible de l'ensemble des indicateurs de santé respectifs de toutes les cellules de la batterie 1.

On va maintenant décrire, en référence avec la figure 3, le dispositif 3 d'évaluation d'un indicateur d'état de santé, ici le SOH, d'une cellule $C_n$ d'une batterie lithium, destiné à mettre en oeuvre le procédé qui vient d'être décrit.

Le dispositif d'évaluation 3 comporte:

• un module 30 d'évaluation d'au moins un couple de tensions à détecter, comportant une tension U1 et une tension U2 ;
• un module 31 de détection d'une phase de charge ou de décharge à régime constant (ou à régime moyen inférieur à C/5) ;

- un module 32 de détection de la première tension U1 prédéterminée et de la deuxième tension U2 prédéterminée, aux bornes d'une cellule $C_n$, respectivement à un premier instant t1 et à un deuxième instant t2, durant une phase de décharge ou de charge de la batterie 1 ;
- un module 33 de calcul d'une quantité de charge électrique réelle, déchargée ou chargée par la cellule $C_n$ entre les instants t1 et t2, par intégration dans le temps d'un courant électrique à travers la cellule $C_n$ ;
- un module 34 de détermination de l'indicateur d'état de santé de la cellule par calcul d'un rapport entre cette quantité de charge électrique réelle calculée et une quantité de charge électrique de référence qui serait déchargée ou chargée par ladite cellule en début de vie lors d'une phase de charge ou de décharge la faisant passer de l'une à l'autre des première et deuxième tensions U1 et U2 ;
- une mémoire 35 de stockage des données $DATA_{cell}$ préétablies relatives à l'évolution de la tension $U_{cell}$ d'une cellule de batterie en début de vie en fonction d'une donnée représentative de la charge électrique de ladite cellule, à différents régimes de ladite cellule comprenant au moins un régime de référence et un autre régime $i$.

Le module de calibration 30 est agencé pour mettre en oeuvre l'étape de calibration E0.

Le module de détection 31 est agencé pour mettre oeuvre l'étape de détection E1.

Le module de détection 32 est destiné à mettre en oeuvre les étapes de détection E2 et E3.

Le module de calcul 33 est agencé pour mettre en oeuvre l'étape de calcul E4.

Le module de détermination du SOH 34 est destiné à mettre en oeuvre l'étape de calcul E5.

Ces différents modules 30 à 34 sont reliées à une unité centrale de commande, en l'espèce un microprocesseur, destiné à commander leur fonctionnement. Ils comprennent des instructions logicielles pour mettre en oeuvre les étapes correspondantes du procédé lorsque ces instructions sont exécutées par l'unité centrale.

Le courant à travers une cellule $C_n$ de la batterie 1 et la tension $U_{cell}$ aux bornes de cette cellule $C_n$ sont mesurés par le système BMS 2 de la batterie 1.

Au lieu de déterminer le SOH comme indicateur d'état de santé d'une cellule, on pourrait déterminer la capacité de la cellule par la relation suivante : $Capa_i = Capa_{ref} * \dfrac{dQ_i}{dQ_{ref}}$ où $dQ_i$ est la quantité de charge électrique déchargée ou chargée par la cellule entre les instants t1 et t2, déterminée par intégration dans le temps du courant électrique à travers la cellule au régime $i$, $dQ_{ref}$ est la quantité de charge électrique qui serait déchargée ou chargée par la cellule en début de vie au régime de référence, pour passer de l'une à l'autre des deux tensions à détecter U1 et U2, et $Capa_{ref}$ est la capacité de la cellule en début de vie au régime de référence.

## Revendications

1. Procédé d'évaluation d'un indicateur d'état de santé (SOH) d'une cellule ($C_n$) d'une batterie lithium (1) composée d'une ou plusieurs cellules ($C_n$) reliées entre elles, comprenant les étapes suivantes :

    • détection (E2, E3) d'une première tension prédéterminée U1 puis d'une deuxième tension prédéterminée U2, de la cellule ($C_n$), respectivement à un premier instant t1 et à un deuxième instant t2, durant une phase de décharge ou de charge de la batterie (1) ;
    • calcul (E4) d'une quantité de charge électrique réelle ($dQ_i$), déchargée ou chargée par la cellule ($C_n$) entre les instants t1 et t2, par intégration dans le temps d'un courant électrique ($I_i$) à travers la cellule ($C_n$) ;

    • détermination (E5) de l'indicateur ($SOH[C_n]$) d'état de santé de la cellule ($C_n$) par calcul d'un rapport $\left(\dfrac{dQ_i}{dQ_{ref}}\right)$ entre ladite quantité de charge électrique réelle calculée et une quantité de charge électrique de référence qui serait déchargée ou chargée par ladite cellule en début de vie lors d'une phase de décharge ou de charge la faisant passer de l'une à l'autre des première et deuxième tensions prédéterminées U1 et U2.

2. Procédé selon la revendication précédente, **caractérisé en ce qu'**il comprend les étapes suivantes :

    • Opération (E0) de calibration comprenant la détermination de deux valeurs de tension prédéterminées U1 et U2 ;
    • L'étape de détection (E2) comprenant la détection de la première tension prédéterminée U1 durant une phase de charge ou de décharge fournit les données de début de l'étape de calcul (E4), et;
    • L'étape de détection (E3) comprenant la détection de la deuxième tension prédéterminée U2 fournit les données de fin de l'étape de calcul (E4).

**3.** Procédé selon la revendication 1 ou 2, **caractérisé en ce que** ladite quantité de charge électrique de référence ($dQ_{ref}$) est la quantité de charge électrique qui serait chargée ou déchargée par la cellule ($C_n$) à un régime de référence, notamment au régime 1C.

**4.** Procédé selon la revendication précédente, **caractérisé en ce que** ladite quantité de charge électrique de référence ($dQ_{ref}$) est déterminée à partir de données préétablies ($DATA_{cell}$) d'évolution de la tension d'une cellule de batterie en début de vie en fonction d'une donnée représentative de la charge électrique de ladite cellule.

**5.** Procédé selon l'une des revendications précédentes, **caractérisé en ce qu'**il comprend une opération (E0) de calibration d'au moins un couple de tensions à détecter, contenant une première tension U1 et une deuxième tension U2, mise en oeuvre à partir de données préétablies ($DATA_{cell}$) relatives à l'évolution de la tension ($U_{cell}$) d'une cellule de batterie en début de vie en fonction d'une donnée représentative de la charge électrique de ladite cellule.

**6.** Procédé selon la revendication précédente, **caractérisé en ce que** l'opération (E0) de calibration d'au moins un couple de tensions à détecter utilise des données préétablies ($DATA_{cell}$) relatives à l'évolution de la tension ($U_{cell}$) d'une cellule de batterie en début de vie en fonction d'une donnée représentative de la charge électrique de ladite cellule à différents régimes comprenant au moins un régime de référence, notamment le régime 1C, et un autre régime $i$, comprend les étapes suivantes :

a) prendre (E01) un couple de tensions à tester, contenant une première tension test $Ut1_p$ et une deuxième tension test $Ut2_q$ ;
b) calculer (E02) une première estimation de la capacité $capa_i$ de la cellule en début de vie, au régime $i$, par la relation $Capa_i = Capa_{ref} * \frac{dQ_i}{dQ_{ref}}$, où

- $Capa_{ref}$ est la capacité de la cellule en début de vie au régime de référence ;
- $dQ_{ref}$ est la quantité de charge électrique qui serait déchargée ou chargée par la cellule en début de vie, au régime de référence, pour passer de l'une à l'autre des deux tensions $Ut1_p$ et $Ut2_q$ ;
- $dQ_i$ est la quantité de charge électrique qui serait déchargée ou chargée par la cellule en début de vie, au régime $i$, pour passer de l'une à l'autre des deux tensions test $Ut1_p$ et $Ut2_q$ ;

c) calculer (E03) une deuxième estimation de la capacité $Capa_i$ de ladite cellule en déterminant la quantité totale de charge électrique qui serait déchargée ou chargée par la cellule en début de vie, au régime $i$, pour passer de l'une à l'autre des deux tensions, minimale et maximale, de la cellule;
d) calculer (E04) une erreur d'estimation ($\varepsilon_i$) entre la première et la deuxième estimation de la capacité $Capa_i$ de la cellule ;
e) choisir (E06) les première et deuxième tensions test $Ut1_p$ et $Ut2_q$ comme première et deuxième tension prédéterminée à détecter U1, U2 si l'erreur d'estimation est inférieure ou égale à un seuil fixé (S), notamment un seuil de 5%, avantageusement de 4%, avantageusement encore de 3%.

**7.** Procédé selon la revendication précédente, **caractérisé en ce qu'**on répète les étapes de calibration a) à e) en fixant l'une des deux tensions test, $Ut1_p$ et $Ut2_q$, et en faisant varier l'autre tension test.

**8.** Procédé selon l'une des revendications 6 et 7, **caractérisé en ce qu'**on répète les étapes de calibration a) à e), d'une part, en fixant la tension à tester $Ut1_p$ et en faisant varier la tension $Ut2_q$ à tester et, d'autre part, en fixant la tension test $Ut2_q$ et en faisant varier la tension test $Ut1_p$.

**9.** Procédé selon l'une des revendications 6 à 8, **caractérisé en ce que**, pour chaque couple de tensions test $Ut1_p$ et $Ut2_q$, les étapes de calibration a) à d) sont mises en oeuvre pour différents régimes $i$ de la cellule, et les tensions test $Ut1_p$ et $Ut2_q$ sont choisies comme première et deuxième tension prédéterminée à détecter U1, U2 si les différentes erreurs d'estimation déterminées pour les différents régimes $i$ sont inférieures ou égales au seuil fixé.

**10.** Procédé selon l'une des revendications précédentes, **caractérisé en ce qu'**on détermine l'état de santé *SOH* de la cellule par la relation suivante : $SOH = 100 * \dfrac{dQ_i}{dQ_{ref}}$ où $dQ_i$ est la quantité de charge électrique déchargée ou chargée par la cellule entre les instants t1 et t2, déterminée par intégration dans le temps du courant électrique à travers la cellule au régime $i$, et $dQ_{ref}$ est la quantité de charge électrique qui serait déchargée ou chargée par la cellule en début de vie au régime de référence, pour passer de l'une à l'autre des deux tensions à détecter U1 et U2.

11. Procédé selon l'une des revendications précédentes, **caractérisé en ce qu'**on détermine la capacité de la cellule par la relation suivante : $Capa_i = Capa_{ref} * \dfrac{dQ_i}{dQ_{ref}}$ où $dQ_i$ est la quantité de charge électrique déchargée ou chargée par la cellule entre les instants t1 et t2, déterminée par intégration dans le temps du courant électrique à travers la cellule au régime $i$, $dQ_{ref}$ est la quantité de charge électrique qui serait déchargée ou chargée par la cellule en début de vie au régime de référence, pour passer de l'une à l'autre des deux tensions à détecter U1 et U2, et $Capa_{ref}$ est la capacité de la cellule en début de vie au régime de référence.

12. Procédé selon l'une des revendications précédentes, **caractérisé en ce qu'**il comprend une étape préalable (E1) de détection d'une phase de charge ou de décharge de la batterie (1) à régime constant, les étapes de détection de la première tension U1 à détecter et de la deuxième tension U2 à détecter étant déclenchées en cas de détection positive.

13. Procédé selon l'une des revendications précédentes, **caractérisé en ce qu'**il comprend une étape préalable de détection d'une phase de charge ou de décharge de la batterie à régime moyen faible inférieur à C/5, les étapes de détection de la première tension U1 à détecter et de la deuxième tension U2 à détecter étant déclenchées en cas de détection positive.

14. Procédé d'évaluation de l'indicateur d'état de santé d'une batterie (1) à partir des indicateurs d'état de santé respectifs des différentes cellules ($C_n$) de ladite batterie (1), **caractérisé en ce qu'**on détermine les indicateurs d'état de santé respectifs de toutes les cellules de la batterie (1) par la mise en oeuvre du procédé selon l'une des revendications 1 à 13 puis on détermine que l'indicateur d'état de santé de la batterie (1) est égal à l'indicateur d'état de santé le plus faible de tous les indicateurs d'état de santé respectifs des cellules de la batterie (1).

15. Dispositif d'évaluation d'un indicateur d'état de santé d'une cellule d'une batterie lithium composée d'une ou plusieurs cellules reliées entre elles, comprenant :

   • un module (32) de détection d'une première tension prédéterminée U1 puis d'une deuxième tension prédéterminée U2, de la cellule, respectivement à un premier instant t1 et à un deuxième instant t2, durant une phase de décharge ou de charge de la batterie ;
   • un module (33) de calcul d'une quantité de charge électrique réelle, déchargée ou chargée par la cellule entre les instants t1 et t2, par intégration dans le temps d'un courant électrique à travers la cellule ;
   • un module (34) de détermination de l'indicateur d'état de santé de la cellule par calcul d'un rapport entre ladite quantité de charge électrique réelle calculée et une quantité de charge électrique de référence qui serait déchargée ou chargée par ladite cellule en début de vie lors d'une phase de charge ou de décharge la faisant passer de l'une à l'autre des première et deuxième tensions U1 et U2.

16. Dispositif selon la revendication précédente, **caractérisé en ce qu'**il comprend un module (30) de calibration d'au moins un couple de tensions à détecter, contenant une première tension U1 et une deuxième tension U2, et une mémoire (35) de stockage de données préétablies relatives à l'évolution de la tension $U_{cell}$ d'une cellule de batterie en début de vie en fonction d'une donnée représentative de la charge électrique de ladite cellule, à différents régimes de ladite cellule comprenant au moins un régime de référence et un autre régime $i$ , le module de calibration étant agencé pour effectuer la calibration sur la base desdites données préétablies et pour:

   a) prendre un couple de tensions à tester, contenant une première tension test $Ut1_p$ et une deuxième tension test $Ut2_q$ ;
   b) calculer une première estimation de la capacité $Capa_i$ de la cellule en début de vie, au régime $i$, par la relation

$$Capa_i = Capa_{ref} * \dfrac{dQ_i}{dQ_{ref}}, \text{ où}$$

- $Capa_{ref}$ est la capacité de la cellule en début de vie au régime de référence ;
- $dQ_{ref}$ est la quantité de charge électrique qui serait déchargée ou chargée par la cellule en début de vie, au régime de référence, pour passer de l'une à l'autre des deux tensions $Ut1_p$ et $Ut2_q$ ;
- $dQ_i$ est la quantité de charge électrique qui serait déchargée ou chargée par la cellule en début de vie, au régime $i$, pour passer de l'une à l'autre des deux tensions test $Ut1_p$ et $Ut2_q$ ;

c) calculer une deuxième estimation de la capacité $Capa_i$ de ladite cellule en déterminant la quantité totale de charge électrique qui serait déchargée ou chargée par la cellule en début de vie, au régime $i$, pour passer de l'une à l'autre des deux tensions, minimale et maximale, de la cellule;
d) calculer une erreur d'estimation entre la première et la deuxième estimation de la capacité $Capa_i$ de la cellule ;
e) choisir les première et deuxième tensions test $Ut1_p$ et $Ut2_q$ comme première et deuxième tension prédéterminée à détecter U1, U2 si l'erreur d'estimation est inférieure ou égale à un seuil fixé, notamment un seuil de 5%, avantageusement de 4%, avantageusement encore de 3%.

**17.** Dispositif selon l'une des revendications 15 et 16, **caractérisé en ce qu'**il comprend un module (31) de détection d'une phase de charge ou de décharge de la batterie (1) à régime constant ou à régime moyen faible inférieur à C/5, la détection de la première tension U1 à détecter et de la deuxième tension U2 à détecter étant déclenchée en cas de détection positive.

Ut1$_p$, Ut2$_q$ — E01

E02_0.5C

E02_2C

E02_3C

E02

EST1_$Capa_{0.5C}$

EST1_$Capa_{2C}$

EST1_$Capa_{3C}$

E03_0.5C

E03_2C

E03_3C

E03

EST2_$Capa_{0.5C}$

EST2_$Capa_{2C}$

EST2_$Capa_{3C}$

$$\varepsilon_i = 100.\frac{\left|EST1_{Capa_i} - EST2_{Capa_i}\right|}{EST2_{Capa_i}}$$ — E04

E0

$\varepsilon_i < S$ ? — E05

N

Y

(Ut1$_p$, Ut2$_q$) ≠ (U1,U2)

(Ut1$_p$, Ut2$_q$) = (U1,U2) — E06

E07

**Figure 1A**

DETECT DCH/CH à REG cst? OU
DETECT DCH/CH à REG$_{mov}$<C/5 ?

**E1**

**N**

**Y**

DETECT U1 à t1     **E2**

DETECT U2 à t2     **E3**

$$dQ_i = \int_{t1}^{t2} I_i \cdot dt = \int_{t1}^{t2} I_{2C} \cdot dt$$

**E4**

$$SOH[C_n] = 100 \cdot \frac{dQ_i}{dQ_{ref}}$$

**E5**

**Figure 1B**

**Figure 2**

**Figure 3**

Europäisches
Patentamt

European
Patent Office

Office européen
des brevets

**RAPPORT DE RECHERCHE EUROPEENNE**

Numéro de la demande

EP 17 17 2398

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2014/300365 A1 (ZIEGLER BERND [DE] ET AL) 9 octobre 2014 (2014-10-09) * alinéa [0028] - alinéa [0031] * * alinéa [0019] - alinéa [0020] * * alinéa [0005] * * alinéa [0008] * | 1-17 | INV. G01R31/36 ADD. H01M10/48 |
| X | JP 2012 058028 A (CALSONIC KANSEI CORP) 22 mars 2012 (2012-03-22) * alinéa [0011] - alinéa [0012] * * alinéa [0019] - alinéa [0020] * * figure 1 * * figure 5 * | 1-17 | |
| X | EP 2 963 432 A1 (HITACHI AUTOMOTIVE SYSTEMS LTD [JP]) 6 janvier 2016 (2016-01-06) * alinéa [0019] * * alinéa [0028] - alinéa [0029] * * alinéa [0038] * * alinéa [0041] - alinéa [0042] * * alinéa [0045] - alinéa [0046] * * alinéa [0048] - alinéa [0049] * * figure 1 * * figure 3 * | 1-17 | |
| X | US 2010/270974 A1 (SAKAKIBARA HISAYOSHI [JP]) 28 octobre 2010 (2010-10-28) * figure 1 * * figure 3 * * alinéa [0028] - alinéa [0030] * * alinéa [0035] * * alinéa [0037] * * alinéa [0042] - alinéa [0044] * | 1-17 | |

DOMAINES TECHNIQUES
RECHERCHES (IPC)

G01R
H01M

-/--

Le présent rapport a été établi pour toutes les revendications

| Lieu de la recherche | Date d'achèvement de la recherche | Examinateur |
|---|---|---|
| Munich | 20 octobre 2017 | Meliani, Chafik |

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

EP 17 17 2398

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2015/015083 A1 (RENAULT SA [FR]) 5 février 2015 (2015-02-05) * figure 2 * * page 10, ligne 10 - ligne 21 * * page 12, ligne 10 - ligne 18 * * page 14, ligne 15 - ligne 21 * ----- | 1-17 | |
| A | WO 2015/086753 A1 (COMMISSARIAT ENERGIE ATOMIQUE [FR]) 18 juin 2015 (2015-06-18) * le document en entier * ----- | 1-17 | |
| A | FR 3 007 531 A1 (COMMISSARIAT ENERGIE ATOMIQUE [FR]) 26 décembre 2014 (2014-12-26) * le document en entier * ----- | 1-17 | |
| A | US 2015/046109 A1 (MIWA TOSHIHARU [JP] ET AL) 12 février 2015 (2015-02-12) * le document en entier * ----- | 1-17 | |
| A | WO 2015/132544 A1 (RENAULT SA [FR]) 11 septembre 2015 (2015-09-11) * le document en entier * ----- | 1-17 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 20 octobre 2017 | Meliani, Chafik |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

& : membre de la même famille, document correspondant

EPO FORM 1503 03.82 (P04C02)

# EP 3 258 282 A1

## ANNEXE AU RAPPORT DE RECHERCHE EUROPEENNE
### RELATIF A LA DEMANDE DE BREVET EUROPEEN NO.

EP 17 17 2398

20-10-2017

| Document brevet cité au rapport de recherche | | Date de publication | Membre(s) de la famille de brevet(s) | | Date de publication |
|---|---|---|---|---|---|
| US 2014300365 | A1 | 09-10-2014 | DE | 102011081800 A1 | 28-02-2013 |
| | | | EP | 2751584 A1 | 09-07-2014 |
| | | | US | 2014300365 A1 | 09-10-2014 |
| | | | WO | 2013029826 A1 | 07-03-2013 |
| JP 2012058028 | A | 22-03-2012 | JP | 5419832 B2 | 19-02-2014 |
| | | | JP | 2012058028 A | 22-03-2012 |
| EP 2963432 | A1 | 06-01-2016 | CN | 105339802 A | 17-02-2016 |
| | | | EP | 2963432 A1 | 06-01-2016 |
| | | | JP | WO2014132403 A1 | 02-02-2017 |
| | | | US | 2015346285 A1 | 03-12-2015 |
| | | | WO | 2014132403 A1 | 04-09-2014 |
| US 2010270974 | A1 | 28-10-2010 | DE | 102010028052 A1 | 25-11-2010 |
| | | | JP | 5434229 B2 | 05-03-2014 |
| | | | JP | 2010259163 A | 11-11-2010 |
| | | | US | 2010270974 A1 | 28-10-2010 |
| WO 2015015083 | A1 | 05-02-2015 | CN | 105556325 A | 04-05-2016 |
| | | | EP | 3028054 A1 | 08-06-2016 |
| | | | FR | 3009093 A1 | 30-01-2015 |
| | | | JP | 2016532866 A | 20-10-2016 |
| | | | KR | 20160039663 A | 11-04-2016 |
| | | | US | 2016187432 A1 | 30-06-2016 |
| | | | WO | 2015015083 A1 | 05-02-2015 |
| WO 2015086753 | A1 | 18-06-2015 | EP | 3080625 A1 | 19-10-2016 |
| | | | FR | 3015046 A1 | 19-06-2015 |
| | | | WO | 2015086753 A1 | 18-06-2015 |
| FR 3007531 | A1 | 26-12-2014 | EP | 3014292 A1 | 04-05-2016 |
| | | | FR | 3007531 A1 | 26-12-2014 |
| | | | JP | 2016531270 A | 06-10-2016 |
| | | | KR | 20160011701 A | 01-02-2016 |
| | | | US | 2016187426 A1 | 30-06-2016 |
| | | | WO | 2014206989 A1 | 31-12-2014 |
| US 2015046109 | A1 | 12-02-2015 | JP | 5768001 B2 | 26-08-2015 |
| | | | JP | 2013225441 A | 31-10-2013 |
| | | | US | 2015046109 A1 | 12-02-2015 |
| | | | WO | 2013161540 A1 | 31-10-2013 |
| WO 2015132544 | A1 | 11-09-2015 | CN | 106133540 A | 16-11-2016 |
| | | | EP | 3114493 A1 | 11-01-2017 |
| | | | FR | 3018360 A1 | 11-09-2015 |

EPO FORM P0460

page 1 de 2

**ANNEXE AU RAPPORT DE RECHERCHE EUROPEENNE
RELATIF A LA DEMANDE DE BREVET EUROPEEN NO.**

EP 17 17 2398

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-10-2017

| Document brevet cité au rapport de recherche | Date de publication | Membre(s) de la famille de brevet(s) | Date de publication |
|---|---|---|---|
| | | JP  2017510800 A | 13-04-2017 |
| | | KR  20160130389 A | 11-11-2016 |
| | | US  2017016961 A1 | 19-01-2017 |
| | | WO  2015132544 A1 | 11-09-2015 |

Pour tout renseignement concernant cette annexe : voir Journal Officiel de l'Office européen des brevets, No.12/82

EPO FORM P0460

page 2 de 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Etude de la seconde vie des batteries des véhicules électriques et hybrides rechargeables. *rapport ADEME,* 2011
- **A. FARMANN ; W. WAAG ; A. MARONGIU ; D. U. SAUER.** Critical review of on-board capacity estimation techniques for lithium-ion batteries in electric and hybrid electric vehicles. *Journal of Power Sources,* 2015, vol. 281, 114-130
- **V. POP ; H.J. BERGVELD ; P.H.L. NOTTEN ; J.H.G. OP HET VELD ; P.P.L. REGTIEN.** Accuracy analysis of the State-of-Charge and remaining run-time determination for lithium-ion batteries. *Measurement,* 2009, vol. 42 (8), 1131-1138